# EUROPÄISCHE PATENTSCHRIFT

(11) **EP 0 499 585 B1**
(45) Veröffentlichungstag und Bekanntmachung des Hinweises auf die Patenterteilung: **02.08.1995**
(21) Anmeldenummer: 92810084.1
(22) Anmeldetag: 06.02.1992
(51) Int. Cl.: C01F 7/02, C08K 3/22

(54) **Füllstoff für wärmeleitende Kunststoffe**
Filler for heat conducting polymers
Charge pour des résines plastiques ayant une conductivité thermique

(30) Priorität: 14.02.1991 CH 454/91
(43) Veröffentlichungstag der Anmeldung: 19.08.1992
(73) Patentinhaber: CIBA-GEIGY AG, 4002 Basel (CH)
(72) Erfinder: Bujard, Patrice, Dr., CH-1784 Courtepin (CH); Sieber, Werner, Dr., CH-1700 Fribourg (CH)

(56) Entgegenhaltungen:
- DE-A- 1 745 062
- CHEMICAL ABSTRACTS, vol. 91, Columbus, Ohio, US; abstract no. 5960B, & JP-A-54 004 985 (NITTO ELECTRIC INDUSTRIAL CO.) 12 März 1979

## Beschreibung

Die vorliegende Erfindung betrifft eine als Füllstoff zur Herstellung von wärmeleitenden Kunststoffen geeignete Zusammensetzung aus drei verschiedenen Fraktionen von Aluminiumoxidteilchen mit jeweils unterschiedlichen Teilchendurchmessern, eine Zusammensetzung aus einem Kunststoff und diesem Füllstoff und die Verwendung der Kunststoffzusammensetzung als Formmassen zur Herstellung von Formteilen und Verbundwerkstoffen.

Es ist bekannt, dass Kunststoffe schlechte Wärmeleiter sind. Zur Verbesserung der Wärmeleitfähigkeit werden Kunststoffen daher feinteilige metallische oder mineralische Füllstoffe einverleibt. Die Verwendung von metallischen Füllstoffen ist nur möglich, wenn keine elektrischen Isoliereigenschaften gefordert sind. Als mineralische Füllstoffe werden häufig Quwarz und amorphes Silica, mit denen man bei hohen Füllgraden eine thermische Leitfähigkeit bis zu etwa 2,5 W/mK, oder besonders Aluminiumoxid eingesetzt, mit dem man eine thermische Leitfähigkeit bis zu etwa 3,5 W/mK erzielen kann. Zur Vermeidung des Abriebs bei Werkzeugen werden zweckmässig sphärische Teilchen eingesetzt. Es ist ferner bekannt, dass der Abrieb durch die Wahl von Teilchen geringer Grösse vermindert werden kann, was aber auch zu einer Verminderung des Füllgrades und damit der Wärmeleitfähigkeit führt.

In CA 112: 57551r (1990) sind thermisch leitende Polymere beschrieben, die elektrisch geschmolzenes Aluminiumoxidpulver als Füllstoff enthalten. Dieser Füllstoff ist bekannterweise abrasiv, was die Anwendungsmöglichkeiten einschränkt.

In CA 112:57894e (1990) sind Epoxidharze mit α-Aluminiumoxid als Füllstoff beschrieben, die einen mittleren Teilchendurchmesser von 5 bis 60 »m aufweisen. Der erzielbare Füllgrad und die thermische Leitfähigkeit werden als nicht ausreichend empfunden.

In CA 111: 175480u (1989) sind thermisch leitende Polymere beschrieben, die eine Mischung aus Aluminiumoxid und hauptsächlich sphärischem Korund mit einem sehr kleinen Teilchendurchmesser zwischen 5 und 10 »m enthalten. Mit diesem Füllstoff können keine hohen Füllgrade und damit hohe thermische Leitfähigkeiten erzielt werden.

Es wurde nun gefunden, dass man sowohl den Füllgrad weiter erhöhen als auch höhere thermische Leitfähigkeiten erzielen kann, wobei die thermischen Ausdehnungskoeffizienten nahe bei denen von Metallen wie zum Beispiel Kupfer, Silber oder Gold liegen, wenn man als Füllstoff ein Gemisch von Aluminiumoxidfraktionen mit unterschiedlicher Partikelgrösse und von unterschiedlicher Gestalt verwendet. Es wurde ferner gefunden, dass mit diesem Füllstoff niedrigviskose Giessharze mit sehr hohem Füllstoffgehalt erhalten werden, die eine ausgezeichnete Giessfähigkeit und damit Verarbeitbarkeit aufweisen.

Ein Gegenstand der Erfindung ist somit ein pulvriges Gemisch aus Aluminiumoxid mit Fraktionen unterschiedlicher Teilchengrösse und äusserer Gestalt, das dadurch gekennzeichnet ist, dass es enthält:
(1) 55 bis 75 Volumen-% sphärisches α-Aluminiumoxid, von dem mindestens 90 Gew.-% einen Teilchendurchmesser von 20 bis 120 »m aufweisen,
(2) 35 bis 20 Volumen-% sphärisches Aluminiumoxid, von dem mindestens 90 Gew.-% einen Teilchendurchmesser von 3 bis 25 »m aufweisen, und
(3) 10 bis 1 Volumen-% Aluminiumoxid mit unregelmässiger Teilchengestalt, von dem mindestens 90 Gew.-% einen Teilchendurchmesser von 1 bis 7 »m aufweisen, wobei sich die Volumen-% zu 100 % addieren.

Die Grössenverteilung der Teilchen wird mit einer Laser-Scanning-Messvorrichtung (Typ CIS der LOT GmbH, Darmstadt, Deutschland) bestimmt. Hierbei werden die Teilchen der mittleren 90 Gew.-% ohne die beiden Schwanzbereiche der Verteilungskurve erfasst. Die Volumenprozente beziehen sich auf die im pulvrigen Gemisch vorhandenen Feststoffe.

In einer bevorzugten Ausführungsform enthält das Gemisch
a) 65 bis 75 Volumen-% der Komponente (1),
b) 35 bis 22 Volumen-% der Komponente (2), und
c) 7 bis 1 Volumen-% der Komponente (3),
wobei sich die Volumen-% zu 100 % addieren.

In einer bevorzugten Ausführungsform enthält das Gemisch
a) 70 bis 75 Volumen-% der Komponente (1),
b) 30 bis 22 Volumen-% der Komponente (2), und
c) 7 bis 1 Volumen-% der Komponente (3),
wobei sich die Volumen-% zu 100 % addieren.

Unregelmässige Gestalt bedeutet nicht nachbehandelte Teilchen, wie sie zum Beispiel nach einem Mahlvorgang vorliegen.

Der Teilchendurchmesser von Komponente (1) beträgt bevorzugt 30 bis 100 »m, von Komponente (2) bevorzugt 3 bis 20 »m und von Komponente (3) bevorzugt 1 bis 5 »m.

Die übrigen 10 Gew.-% der Komponente (1) können Teilchen mit einem Durchmesser von mehr als 120 »m und bis zu 200 »m sowie von weniger als 20 »m und bis zu 0,1 »m, der Komponente (2) können Teilchen mit einem Durchmesser von mehr als 25 »m und bis zu 40 »m sowie von weniger als 3 »m und bis zu 0,01 »m, und der Komponente (3) können Teilchen mit einem Durchmeser von mehr als 7 »m und bis zu 20 »m und weniger als 1 »m und bis zu 0,001 »m enthalten.

Die erfindungsgemässen Gemische können durch Vermischen der drei Komponenten hergestellt werden. Teilchenförmige Aluminiumoxide sind bekannt und kommerziell erhältlich. Fraktionen mit definierten Bereichen der Teilchengrössen sind durch übliche Trennverfahren erhältlich. Mit den Trennverfahren können auch Fraktionen so hergestellt werden, dass der Anteil der Schwanzbereiche der Verteilungskurven vermindert oder entfernt wird. So können die drei Fraktionen im erfindungsgemässen pulvrigen Gemisch mindestens 95 Gew.% oder 100 Gew.-% Teilchen mit den zuvor definierten Teilchendurchmessern enthalten. Sphärische Teilchen können zum Beispiel durch Sinterverfahren oder Schmelzverfahren hergestellt werden. Die Herstellung verschiedener Modifikationen von Aluminiumoxidteilchen ist allgemein bekannt. Die Komponenten (2) und (3) können unterschiedliche Modifikationen aufweisen.

Die erfindungsgemässen Gemische eignen sich hervorragend als Füllstoffe für Polymere, um die Wärmeleitfähigkeit zu erhöhen, wobei die Abrasivität der Zusammensetzung gering ist.

Ein weiterer Gegenstand der Erfindung ist eine Zusammensetzung, enthaltend in gleichmässiger Verteilung
a) 10 bis 95 Gew.-% eines thermoplastischen oder strukturell vernetzten Polymeren, und
b) 90 bis 5 Gew.-% des zuvor beschriebenen pulvrigen Gemischs.

Die Zusammensetzung enthält im allgemeinen bevorzugt 10 bis 90 Gew.-% Polymer und 90 bis 10 Gew.-% des pulvrigen Gemischs. Je nach Verwendungszweck kann der Gehalt des pulvrigen Gemischs im Polymer unterschiedlich hoch sein. So kann für viele Formteile, für die keine sehr hohe Wärmeleitfähigkeit gefordert ist, ein Gehalt von 5 bis 50 Gew.-%, bevorzugt 10 bis 40 Gew.-% des pulvrigen Gemischs den Anforderungen an Gebrauchsgegenstände zur Wärmeableitung genügen. Wenn eine sehr hohe Wärmeleitfähigkeit erzielt werden soll, zum Beispiel bei Klebern für die Verbindung von Metallteilen oder Giessharzen für die Umhüllung von elektrischen oder elektronischen Bauteilen, beträgt der Gehalt des pulvrigen Gemischs im allgemeinen mehr als 50 Gew.-%, bevorzugt 60 bis 90 Gew.-% und besonders 70 bis 90 Gew.-%.

Bei den thermoplastischen Polymeren kann es sich zum Beispiel um die folgenden Polymeren, Copolymeren bzw. Mischungen von diesen Polymeren handeln:
1. Polymere von Mono- und Diolefinen, beispielsweise Polypropylen, Polyisobutylen, Polybuten- 1, Polymethylpenten-1, Polyisopren oder Polybutadien sowie Polymerisate von Cycloolefinen wie z.B. von Cyclopenten oder Norbornen; ferner Polyethylen (das gegebenenfalls vernetzt sein kann), z.B. Polyethylen hoher Dichte (HDPE), Polyethylen niederer Dichte (LDPE), lineares Polyethylen niederer Dichte (LLDPE).
2. Mischungen der unter 1) genannten Polymeren, z.B. Mischungen von Polypropylen mit Polyisobutylen, Polypropylen mit Polyethylen (z.B. PP/HDPE, PP/LDPE) und Mischungen verschiedener Polyethylentypen (z.B. LDPE/HDPE).
3. Copolymere von Mono- und Diolefinen untereinander oder mit anderen Vinylmonomeren, wie z.B. Ethylen-Propylen-Copolymere, lineares Polyethylen niederer Dichte (LLDPE) und Mischungen desselben mit Polyethylen niederer Dichte (LDPE), Propylen-Buten-1-Copolymere, Propylen-Isobutylen-Copolymere, Ethylen-Buten-1-Copolymere, Ethylen-Hexen-Copolymere, Ethylen-Methylpenten-Copolymere, Ethylen-Hepten-Copolymere, Ethylen-Octen-Copolymere, Propylen-Butadien-Copolymere, Isobutylen-Isopren-Copolymere, Ethylen-Alkylacrylat-Copolymere, Ethylen-Alkylmethacrylat- Copolymere, Ethylen-Vinylacetat-Copolymere oder Ethylen-Acrylsäure-Copolymere und deren Salze (Ionomere), sowie Terpolymere von Ethylen mit Propylen und einem Dien, wie Hexadien, Dicyclopentadien oder Ethylidennorbornen; ferner Mischungen solcher Copolymere untereinander und mit unter 1) genannten Polymeren, z.B. Polypropylen/Ethylen-Propylen-Copolymere, LDPE/Ethylen-Vinylacetat-Copolymere, LDPE/Ethylen-Acrylsäure-Copolymere, LLDPE/Ethylen-Vinylacetat-Copolymere und LLDPE/Ethylen-Acrylsäure-Copolymere.
3a. Kohlenwasserstoffharze (z.B. C₅-C₉) inklusive hydrierte Modifikationen davon (z.B. Klebrigmacherharze).
4. Polystyrol, Poly-(p-methylstyrol), Poly-(α-methylstyrol).
5. Copolymere von Styrol oder α-Methylstyrol mit Dienen oder Acrylderivaten, wie z.B. Styrol-Butadien, Styrol-Acrylnitril, Styrol-Alkylmethacrylat, Styrol-Butadien-Alkylacrylat, Styrol-Maleinsäureanhydrid, Styrol-Acrylnitril-Methylacrylat; Mischungen von hoher Schlagzähigkeit aus Styrol-Copolymeren und einem anderen Polymer, wie z.B. einem Polyacrylat, einem Dien-Polymeren oder einem Ethylen-Propylen-Dien-Terpolymeren; sowie Block-Copolymere des Styrols, wie z.B. Styrol-Butadien-Styrol, Styrol-Isopren-Styrol, Styrol-Ethylen/Butylen-Styrol oder Styrol-Ethylen/Propylen-Styrol.
6. Pfropfcopolymere von Styrol oder α-Methylstyrol, wie z.B. Styrol auf Polybutadien, Styrol auf Polybutadien-Styrol- oder Polybutadien-Acrylnitril-Copolymere, Styrol und Acrylnitril (bzw. Methacrylnitril) auf Polybutadien; Styrol, Acrylnitril und Methylmethacrylat auf Polybutadien; Styrol und Maleinsäureanhydrid auf Polybutadien; Styrol, Acrylnitril und Maleinsäureanhydrid oder Maleinsäureimid auf Polybutadien; Styrol und Maleinsäureimid auf Polybutadien, Styrol und Alkylacrylate bzw. Alkylmethacrylate auf Polybutadien, Styrol und Acrylnitril auf Ethylen-Propylen-Dien-Terpolymeren, Styrol und Acrylnitril auf Polyalkylacrylaten oder Polyalkylmethacrylaten, Styrol und Acrylnitril auf Acrylat-Butadien-Copolymeren, sowie deren Mischungen mit den unter 5) genannten Copolymeren, wie sie z.B. als sogenannte ABS-, MBS-, ASA- oder AES-Polymere bekannt sind.
7. Halogenhaltige Polymere, wie z.B. Polychloropren, Chlorkautschuk, chloriertes oder chlorsulfoniertes Polyethylen, Copolymere von Ethylen und chloriertem Ethylen, Epichlorhydrinhomo- und -copolymere, insbesondere Polymere aus halogenhaltigen Vinylverbindungen, wie z.B. Polyvinylchlorid, Polyvinylidenchlorid, Polyvinylfluorid, Polyvinylidenfluorid; sowie deren Copolymere, wie Vinylchlorid-Vinylidenchlorid, Vinylchlorid-Vinylacetat oder Vinylidenchlorid-Vinylacetat.
8. Polymere, die sich von α,β-ungesättigten Säuren und deren Derivaten ableiten, wie Polyacrylate und Polymethacrylate, Polyacrylamide und Polyacrylnitrile.
9. Copolymere der unter 8) genannten Monomeren untereinander oder mit anderen ungesättigten Monomeren, wie z.B. Acrylnitril-Butadien-Copolymere, Acrylnitril-Alkylacrylat-Copolymere, Acrylnitril-Alkoxyalkylacrylat-Copolymere, Acrylnitril-Vinylhalogenid-Copolymere oder Acrylnitril-Alkylmethacrylat-Butadien-Terpolymere.
10. Polymere, die sich von ungesättigten Alkoholen und Aminen bzw. deren Acylderivaten oder Acetalen ableiten, wie Polyvinylalkohol, Polyvinylacetat, -stearat, -benzoat, -maleat, Polyvinylbutyral, Polyallylphthalat, Polyallylmelamin; sowie deren Copolymere mit in Punkt 1 genannten Olefinen.
11. Homo- und Copolymere von cyclischen Ethern, wie Polyalkylenglykole, Polyethylenoxyd, Polypropylenoxyd oder deren Copolymere mit Bisglycidylethern.
12. Polyacetale, wie Polyoxymethylen, sowie solche Polyoxymethylene, die Comonomere, wie z.B. Ethylenoxid, enthalten; Polyacetale, die mit thermoplastischen Polyurethanen, Acrylaten oder MBS modifiziert sind.
13. Polyphenylenoxide und -sulfide und deren Mischungen mit Styrolpolymeren oder Polyamiden.
14. Polyurethane, die sich von Polyethern, Polyestern und Polybutadienen mit endständigen Hydroxylgruppen einerseits und aliphatischen oder aromatischen Polyisocyanaten andererseits ableiten, sowie deren Vorprodukte.
15. Polyamide und Copolyamide, die sich von Diaminen und Dicarbonsäuren und/oder von Aminocarbonsäuren oder den entsprechenden Lactamen ableiten, wie Polyamid 4, Polyamid 6, Polyamid 6/6, 6/10, 6/9, 6/12, 4/6, Polyamid 11, Polyamid 12, aromatische Polyamide ausgehend von m-Xylylendiamin und Adipinsäure; Polyamide, hergestellt aus Hexamethylendiamin und Iso- und/oder Terephthalsäure und gegebenenfalls einem Elastomer als Modifikator, z.B. Poly-2,4,4-trimethylhexamethylenterephthalamid, Poly-m-phenylen-isophthalamid. Block-Copolymere der vorstehend genanntenPolyamide mit Polyolefinen, Olefin-Copolymeren, Ionomeren oder chemisch gebundenen oder gepfropften Elastomeren; oder mit Polyethern, wie z.B. mit Polyethylenglykol, Polypropylenglykol oder Polytetramethylenglykol. Ferner mit EPDM oder ABS modifizierte Polyamide oder Copolyamide; sowie während der Verarbeitung kondensierte Polyamide ("RIM-Polyamidsysteme").
16. Polyharnstoffe, Polyimide, Polyamid-imide und Polybenzimidazole.
17. Polyester, die sich von Dicarbonsäuren und Dialkoholen und/oder von Hydroxycarbonsäuren oder den entsprechenden Lactonen ableiten, wie Polyethylenterephthalat, Polybutylenterephthalat, Poly-1,4-dimethylolcyclohexanterephthalat, Polyhydroxybenzoate, sowie Block-Polyether-ester, die sich von Polyethern mit Hydroxylendgruppen ableiten; ferner mit Polycarbonaten oder MBS modifizierte Polyester.
18. Polycarbonate und Polyestercarbonate.
19. Polysulfone, Polyethersulfone und Polyetherketone.
20. Polyether aus Diglycidylverbindungen, zum Beispiel Diglycidylethern und Diolen, z. B. aus Bisphenol-A-Diglycidylether und Bisphenol-A.
21. Natürliche Polymere, wie Cellulose, Naturkautschuk, Gelatine, sowie deren polymerhomolog chemisch abgewandelte Derivate, wie Celluloseacetate, -propionate und -butyrate, bzw. die Celluloseether, wie Methylcellulose; sowie Kolophoniumharze und Derivate.
22. Mischungen (Polyblends) der vorgenannten Polymeren, wie z.B. PP/EPDM, Polyamid/EPDM oder ABS, PVC/EVA, PVC/ABS, PVC/MBS, PC/ABS, PBTP/ABS, PC/ASA, PC/PBT, PVC/CPE, PVC/Acrylate, POM/thermoplastisches PUR, PC/thermoplastisches PUR, POM/Acrylat, POM/MBS, PPO/HIPS, PPO/PA 6.6 und Copolymere, PA/HDPE, PA/PP, PA/PPO.

Bei den strukturell vernetzten Polymeren kann es sich zum Beispiel um folgende Polymere handeln:
1. Vernetzte Polymere, die sich von Aldehyden einerseits und Phenolen, Harnstoff oder Melamin andererseits ableiten, wie Phenol-Formaldehyd-, Harnstoff-Formaldehyd- und Melamin-Formaldehydharze.
2. Trocknende und nicht-trocknende Alkydharze.
3. Ungesättigte Polyesterharze, die sich von Copolyestern gesättigter und ungesättigter Dicarbonsäuren mit mehrwertigen Alkoholen, sowie Vinylverbindungen als Vernetzungsmittel ableiten, wie auch deren halogenhaltige, schwerbrennbare Modifikationen.
4. Vernetzbare Acrylharze, die sich von substituierten Acrylsäureestern ableiten, wie z.B. von Epoxyacrylaten, Urethan-acrylaten oder Polyester-acrylaten.
5. Alkydharze, Polyesterharze und Acrylatharze, die mit Melaminharzen, Harnstoffharzen, Polyisocyanaten oder Epoxidharzen vernetzt sind.
6. Kautschuk auf der Basis von vernetzten Polydienen, zum Beispiel Butadien oder Isopren; Silikonkautschuk.
7. Epoxidharze, die sich von Polyepoxiden ableiten, z.B. von Bisglycidylethern von Polyolen oder von cycloaliphatischen Diepoxiden.

Unter den vernetzten Polymeren sind vernetzte Epoxidharze bevorzugt, denen als Polyepoxide bevorzugt Glycidylverbindungen mit durchschnittlich zwei Epoxidgruppen im Molekül zu Grunde liegen. Als Glycidylverbindungen kommen vor allem solche mit zwei an ein Heteroatom (z.B. Schwefel, vorzugsweise Sauerstoff oder Stickstoft) gebundenen Glycidylgruppen, β-Methylglycidylgruppen oder 2,3-Epoxycyclopentylgruppen in Frage; genannt seien insbesondere Bis-(2,3-epoxycyclopentyl)-ether; Diglycidylether von mehrwertigen aliphatischen Alkoholen, wie 1,4-Butandiol, oder Polyalkylenglykolen, wie Polypropylenglykole; Diglycidylether von cycloaliphatischen Polyolen` wie 2,2-Bis-(4-hydroxycyclohexyl)-propan; Diglycidylether von mehrwertigen Phenolen, wie Resorcin, Bis-(p-hydioxyphenyl)-methan, 2,2-Bis-(p-hydroxyphenyl)-propan (=Diomethan), 2,2-Bis-(4'-hydroxy-3',5'-dibromphenyl)-propan, 1,3-Di-(p-hydroxyphenyl)-ethan; Di-(β-methylglycidyl)-ether der oben angeführten zweiwertigen Alkohole oder zweiwertigen Phenole; Diglycidylester von Dicarbonsäuren, wie Phthalsäure, Terephthalsäure, Δ₄-Teträhydrophthalsäure und Hexahydrophthalsäure; N,N-Diglycidylderivate von primären Aminen und Amiden und heterocyclischen, zwei N-Atome enthaltenden Stickstoffbasen, und N,N'-Diglycidylderivate von disekundären Diamiden und Diaminen, wie N,N-Diglycidylanilin, N,N-Diglycidyltoluidin, N,N-Diglycidyl-p-aminophenyl-methyl-ether, N,N'-Dimethyl-N,N'-diglycidyl-bis-(p-aminophenyl)-methan; N',N''-Diglycidyl-N-phenyl-isocyanurat; N,N'-Diglycidylethylenharnstoff; N,N'-Diglycidyl-5,5-dimethyl-hydantoin, N,N'-Diglycidyl-5-isopropyl-hydantoin, N,N-Methylen-bis-(N',N'-diglycidyl-5,5-dimethylhydantoin), 1,3-Bis-(N-glycidyl-5,5-dimethylhydantoin)-2-hydroxypropan; N,N'-Diglycidyl-5,5-dimethyl-6-isopropyl-5,6-dihydro-uracil, Triglycidylisocyanurat.

Eine bevorzugte Gruppe von Epoxidharzen sind glycidylierte Novolake, Hydantoine, Aminophenole, Bisphenole und aromatische Diamine oder cycloaliphatische Epoxidverbindungen. Besonders bevorzugte Epoxidharze sind glycidylierte Kresolnovolake, Bisphenol-A- und Bisphenol-F-diglycidylether, Hydantoin-N,N'-bisglycid, p-Aminophenoltriglycid, Diaminodiphenylmethantetraglycid, Vinylcyclohexendioxid, 3,4-Epoxycyclohexylmethyl-3,4-epoxycyclohexancarboxylat oder Mischungen hiervon.

Geeignet sind auch vorreagierte Addukte solcher Epoxidverbindungen mit Epoxidhärtern, zum Beispiel ein Addukt aus Bisphenol-A-diglycidylether und Bisphenol-A, oder mit Oligoestern mit zwei terminalen Carboxylgruppen und Epoxiden vorreagierte Addukte.

Als Härter für Epoxidharze kommen saure oder basische Verbindungen in Frage. Als geeignete Härter seien zum Beispiel genannt: Amine, wie zum Beispiel aliphatische, cycloaliphatische oder aromatische, primäre, sekundaäre und tertiäre Amine, z. B. Ethylendiamin, Hexamethylendiamin, Trimethylhexamethylendiamin, Dietylentriamin, Triethylentetraamin, Teraethylenpentaamin, N,N-Dimethylpropylen- 1,3-diamin, N,N-Diethylpropylen-1,3-diamin, 2,2-Bis-(4'-aminocyclohexyl)-propan, 3,3,5-Trimethyl-3-(aminomethyl)-cyclohexylamin (Isophorondiamin), Mannichbasen wie z. B. 2,4,6-Tris-(dimethylaminomethyl)-phenol, m-Phenylendiamin, p-Phenylendiamin, Bis-(4-aminophenyl)-methan, Bis-(4-aminophenyl)-sulfon, Xylylendiamin; Aminoalkohole wie z. B. Aminoethanol, 1,3-Aminopropanol, Diethanolamin oder Triethanolamin; Addukte von Acrylnitril an Polyalkylenpolyamine oder Monoepoxiden (Ethylenoxid, Propylenoxid) an Polyalkylenpolyamine (Diethylentriamin, Triethylentetraamin; Addukte aus einem Ueberschuss Polyaminen (Diethylentriamin, Triethylentetraamin) und Polyepoxiden wie z. B. Bisphenol-A-diglycidylethern; Polyamide, insbesondere solche aus aliphatischen Polyaminen (Diethylentriamin, Triethylentetraamin) und di- oder trimerisierten ungesättigten Fettsäuren (dimerisierte Leinölfettsäure, Versamid®); Dicyandiamid; Polysulfide (Thiokol®); Anilin-Formaldehyde; mehrwertige Phenole (Resorcin, 2,2-Bis-(4-hydroxyphenyl)-propan) oder Phenol-Formaldehyd-Harze; mehrbasische Carbonsäuren und ihre Anhydride` z. B. Phthalsäureanhydrid, Tetrahydrophthalsäureanhydrid, Hexahydrophthalsäureanhydrid, 4-Methylhexahydrophthalsäureanhydrid, 3,6-Endomethylen-tetrahydrophthalsäreanhydrid, 4-Methyl-3,6-endomethylen-tetrahydrophthalsäureanhydrid (Methylnadicanhydrid), 3,4,5,6,7,7-Hexachlor-endomethylen-tetrahydrophthalsäureanhydrid, Bernsteinsäureanhydrid, Adipinsäureanhydrid, Trimethyladipinsäureanhydrid, Sebacinsäureanhydrid, Maleinsäureanhydrid, Dodecylbernsteinsäureanhydrid, Pyromellitsäuredianhydrid, Trimellitsäureanhydrid, Benzophenontetracarbonsäuredianhydrid, oder Gemische solcher Anhydride.

Eine bevorzugte Gruppe von Härtern sind Polyamine, Novolake, Polyaminoamide und Polycarbonsäureanhydride.

Die Epoxidharze können auch zusätzlich mit Härtungsbeschleunigern oder nur mit thermischen Härtungskatalysatoren gehärtet werden. Beispiele sind tertiäre Amine, deren Salze oder quaternäre Ammoniumverbindungen (2,4,6-Tris-(dimethylaminomethyl)phenol, Benzyldimethylamin, 2-Ethyl-4-methylimidazol, Triamylammoniumphenolat); Mono- oder Polyphenole (Phenol, Diomenthan, Salicylsäure); Bortrifluorid und seine Komplexe mit organischen Verbindungen wie z. B. Bortrifluorid-Etherkomplexe und Bortrifluorid-Amin-Komplexe (BF₃-Monoethylamin-Komplex); Phosphorsäure und Triphenylphosphit.

Härtungsbeschleuniger und Katalysatoren werden üblicherweise in einer Menge von 0,1 bis 10 Gew.-% zugegeben, bezogen auf das Epoxidharz. Härter für Epoxidharze werden im allgemeinen in äquimolaren Mengen verwendet, bezogen auf die Epoxidgruppen und funktionellen Gruppen eines Härters.

Der erfindungsgemässen Zusammensetzung können weitere Additive zur Verbesserung der Verarbeitungseigenschaften, der mechanischen, elektrischen und thermischen Eigenschaften, der Oberflächeneigenschaften und der Lichtstabilität einverleibt sein, zum Beispiel feinteilige Füllstoffe, Verstärkerfüllstoffe, Weichmacher, Gleit- und Entformungsmittel, Haftvermittler, Antioxidantien, Wärme- und Lichtstabilisatoren, Pigmente und Farbstoffe. Werden weitere Füllstoffe und/oder Verstärkerfüllstoffe mitverwendet, so beträgt deren Höchstmenge zweckmässig zusammen mit dem erfindungsgemässen pulvrigen Gemisch höchstens 95 Gew.-%, bevorzugt höchstens 90 Gew.-%, bezogen auf die Zusammensetzung.

Die Herstellung der erfindungsgemässen Zusammensetzung kann nach in der Kunststofftechnik bekannten Verfahren erfolgen, zum Beispiel durch Vermischen des feinteiligen wärmeleitenden Füllstoffs mit dem Kunststoff vor, während oder nach der Herstellung, durch Plastifizieren des Kunststoffs und Vermischen mit dem Füllstoff mittels Kalandrieren, Kneten, Extrudieren oder Spritzgiesen zur Herstellung von Granulaten oder Formkörpern. Es ist auch möglich, Kunststoffpulver mit dem Füllstoff trocken zu vermischen oder den Füllstoff in einer Kunststofflösung zu suspendieren und dann das Lösungsmittel zu entfernen.

Bei Duroplasten und strukturell vernetzten Polymeren wird der feinteilige Füllstoff zweckmässig vor der Formgebung und vor dem Härten bzw. Vernetzen zugesetzt, zum Beispiel durch gemeinsames Vermischen der Kunststoffkomponenten mit dem Füllstoff, wobei dieser zuvor einer Komponente einverleibt werden kann.

Das erfindungsgemässe pulvrige Gemisch kann dem Kunststoff in Form des Gemischs selbst, in Kombination von 2 Komponenten und danach der Zugabe der dritten Komponente oder durch die aufeinanderfolgende Zugabe der einzelnen Komponenten einverleibt werden.

Das erfindungsgemässe Gemisch eignet sich besonders zur Herstellung von hochgefüllten Giessharzen auf der Basis von Epoxidharzen, wobei daraus hergestellte Formkörper Wärmeleitfähigkeiten bei relativ niedrigen Temperaturen von über 3,2 und sogar über 4 W/mK aufweisen können. Trotz der hohen Füllgrade ist die Viskosität der Giessharze noch so niedrig, dass sie gegebenenfalls bei Erwärmung und/oder Vibration fliessfähig sind und gut zu Formteilen verarbeitet werden können.

Ein weiterer Gegenstand der Erfindung ist ein Giessharz auf der Basis von Epoxidharzen, das dadurch gekennzeichnet ist, dass es in gleichmässiger Verteilung 70 bis 90 Gew.-%, bevorzugt 75 bis 90 Gew.-% und besonders bevorzugt 80 bis 90 Gew.-% des erfindungsgemässen pulvrigen Gemischs von Aluminiumoxiden enthält.

In Frage kommende Epoxidharze sind zuvor erwähnt worden. Bevorzugte Epoxidharze sind solche auf der Basis von gegebenenfalls vorverlängerten Bisphenoldiglycidylethern, zum Beispiel Bisphenol-A- und Bisphenol-F-diglycidylether, und Polycarbonsäureanhydriden, zum Beispiel Phthalsäure- und Hydrophthalsäureanhydride als Härtern, die bevorzugt in Anwesenheit eines Härtungsbeschleunigers gehärtet werden, zum Beispiel von N-Methylimidazol.

Die erfindungsgemässe Zusammensetzung ist eine wertvolle Formmasse zur Herstellung wärmeleitender Formteile aller Art, zum Beispiel Filmen, Folien, Bändern, Fasern, Platten, Halbzeug, Formkörpern und Gehäusen. Hierbei können die für die Kunststoffverarbeitung üblichen Verfahren angewendet werden, zum Beispiel Giessen, Kalandrieren, Spritzgiessen, Spritzpressen, Extrudieren, Tiefziehen, Press- und Sinterverfahren. Die erfindungsgemässe Zusammensetzung eignet sich besonders zur Herstellung von Heizkörpern, Klebhazzen und Schmelzklebern bevorzugt für die Verbindung von Metallen, sowie als wärmeleitendes Versiegelungsmaterial besonders für elektrische und elektronische Bauteile.

Ein weiterer Gegenstand der Erfindung ist die Verwendung der erfindungsgemässen Zusammensetzung oder des erfindungsgemässen Giessharzes zur Herstellung von wärmeleitenden Formteilen und Verbundwerkstoffen.

Ein anderer Gegenstand der Erfindung ist die Verwendung des Giessharzes als Klebharz zur Verbindung von Metallen oder als Versiegelungsmaterial für elektrische und elektronische Bauteile.

Die nachfolgenden Beispiele erläutern die Erfindung näher. Die Wärmeleitfähigkeit wird durch die thermische Vergleichsmethode mit Pyroceram® 9606 als Referenzmaterial gemessen. Die Methode ist von L. C. Hulstrom et al. in "Round-Robin Testing Of Thermal Conductivity Reference Materials", Proceeding of thermal conductivity 19, October 20-23,1985, Cookevelli, Tennesse, edited by D.W. Yarbrough, beschrieben.

Beispiel 1: Für die Herstellung eines Giessharzes werden folgende Aluminiumoxidfraktionen ausgewählt:
1. Gesintertes, sphärisches α-Al₂O₃, mittlerer Durchmesser 47 »m, Teilchendurchmesser der mittleren 90 Gew.-% von 30 bis 100 »m.
2. Kommerzielles sphärisches α- und δ-Al₂O₃ (Alunabeads CBA-10®, Showa Denko, Japan), mittlerer Durchmesser 9 »m, Teilchendurchmesser der mittleren 90 Gew.-% von 3 bis 20 »m.
3. Kommerzielles Al₂O₃ (CTB 5/6FG®, Alcoa), mittlerer Durchmesser 3,5 »m, Teilchendurchmesser der mittleren 90 Gew.-% von 1 bis 5 »m.

71 Gew.-% (70 Vol.-%) der 1. Komponente und 28 Gew.-% (29 Vol.-%) der 2. Komponente werden in einer Polypropylenflasche während 7 Stunden gerührt (Rührer mit beweglichen Rührblättern). Danach gibt man 1 Gew.-% (1 Vol.-%) der 3. Komponente zu und rührt eine weitere Stunde.
Das pulvrige Gemisch wird bei 80 °C unter Rühren einem Epoxidgiessharz aus 50,9 Gew.-% Bisphenol-F-diglycidylether, 48,9 Gew.-% Hexahydrophthalsäureanhydrid und 0,2 Gew.-% N-Methylimidazol in gleichmässiger Verteilung einverleibt. Die Menge ist so bemessen, dass die Zusammensetzung unter Vibration noch giessfähig ist. Die Zusammensetzung wird in eine Aluminiumform gegossen und anschliessend 4 Stunden bei 80 °C und 18 Stunden bei 120 °C gehärtet. Der Gehalt an pulvrigem Gemisch wird über die Dichte bestimmt und beträgt 73 Vol.-% (89,4 Gew.-%). Der gehärtete Probenkörper weist bei 40 °C eine Wärmeleitfähigkeit von 4,05 W/mK auf.

Beispiel 2: Gemäss Beispiel 1 wird ein Epoxidgiessharz mit 88 Gew.-% (70,2 Vol.-%) der folgenden Füllstoffmischung hergestellt:
72,9 Gew.-% (72 Vol.-%) Komponente 1. gemäss Beispiel 1;
23,1 Gew.-% (24 Vol.-%) Komponente 2. gemäss Beispiel 1;
4 Gew.-% (4 Vol.-%) Komponente 3. gemäss Beispiel 1.
Die Wärmeleitfähigkeit beträgt 3,6 W/mK.

Beispiel 3: Gemäss Beispiel 1 wird ein Epoxidgiessharz mit 87,6 Gew.-% (69,3 Vol.-%) der folgenden Füllstoffmischung hergestellt:
73,8 Gew.-% (73 Vol.-%) Komponente 1. gemäss Beispiel 1;
22,2 Gew.-% (23 Vol.-%) Komponente 2. gemäss Beispiel 1;
4 Gew.-% (4 Vol.-%) Komponente 3. gemäss Beispiel 1.
Die Wärmeleitfähigkeit beträgt 3,3 W/mK.

Beispiel 4: Gemäss Beispiel 1 wird ein Epoxidgiessharz mit 88,4 Gew.-% (70,9 Vol.-%) der folgenden Füllstoffmischung hergestellt:
59 Gew.-% (58 Vol.-%) Komponente 1. gemäss Beispiel 1;
35 Gew.-% (34 Vol.-%) Komponente 2. gemäss Beispiel 1;
7 Gew.-% (4 Vol.-%) Komponente 3. gemäss Beispiel 1.
Die Wärmeleitfähigkeit beträgt 3,8 W/mK.

## Patentansprüche

1. Pulvriges Gemisch aus Aluminiumoxid mit Fraktionen unterschiedlicher Teilchengrösse und äusserer Gestalt, dadurch gekennzeichnet, dass es enthält:
(1) 55 bis 75 Volumen-% sphärisches α-Aluminiumoxid, von dem mindestens 90 Gew.-% einen Teilchendurchmesser von 20 bis 120 »m aufweisen,
(2) 35 bis 20 Volumen-% sphärisches Aluminiumoxid, von dem mindestens 90 Gew.-% einen Teilchendurchmesser von 3 bis 25 »m aufweisen, und
(3) 10 bis 1 Volumen-% Aluminiumoxid mit unregelmässiger Teilchengestalt, von dem mindestens 90 Gew.-% einen Teilchendurchmesser von 1 bis 7 »m aufweisen,
wobei sich die Volumen-% zu 100 % addieren.

2. Gemisch gemäss Anspruch 1, dadurch gekennzeichnet, dass es
a) 65 bis 75 Volumen-% der Komponente (1),
b) 35 bis 22 Volumen-% der Komponente (2), und
c) 7 bis 1 Volumen-% der Komponente (3)enthält,
wobei sich die Volumen-% zu 100 % addieren.

3. Gemisch gemäss Anspruch 1, dadurch gekennzeichnet, dass es
a) 70 bis 75 Volumen-% der Komponente (1),
b) 30 bis 22 Volumen-% der Komponente (2), und
c) 7 bis 1 Volumen-% der Komponente (3), enthält,
wobei sich die Volumen-% zu 100 % addieren.

4. Gemisch gemäss Anspruch 1, dadurch gekennzeichnet, dass der Teilchendurchmesser von Komponente (1) 30 bis 100 »m, von Komponente (2) 3 bis 20 »m und von Komponente (3) 1 bis 5 »m beträgt.

5. Zusammensetzung, enthaltend in gleichmässiger Verteilung
a) 10 bis 95 Gew.-% eines thermoplastischen oder strukturell vernetzten Polymeren, und
b) 90 bis 5 Gew.-% des pulvrigen Gemischs gemäss Anspruch 1.

6. Zusammensetzung gemäss Anspruch 5, dadurch gekennzeichnet, dass sie 10 bis 90 Gew.-% Polymer und 90 bis 10 Gew.-% des pulvrigen Gemischs enthält.

7. Zusammensetzung gemäss Anspruch 5, dadurch gekennzeichnet, dass es sich bei dem strukturell vernetzten Polymer um ein Epoxidharz handelt.

8. Giessharz auf der Basis von Epoxidharzen, dadurch gekennzeichnet dass es in gleich-mässiger Verteilung 70 bis 90 Gew.-% des pulvrigen Gemischs gemäss Anspruch 1 enthält, bezogen auf das Giessharz.

9. Giessharz gemäss Anspruch 8, dadurch gekennzeichnet, dass es 75 bis 90 Gew.-% des pulvrigen Gemischs enthält.

10. Giessharz gemäss Anspruch 8, dadurch gekennzeichnet, dass es 80 bis 90 Gew.-% des pulvrigen Gemischs enthält.

11. Giessharz gemäss Anspruch 8, dadurch gekennzeichnet, dass es als Harzkomponente eine Mischung aus Bisphenoldiglycidylethern und einem Polycarbonsäureanhydrid als Härter enthält.

12. Giessharz gemäss Anspruch 11, dadurch gekennzeichnet, dass es zusätzlich einen Härtungsbeschleuniger enthält.

13. Giessharz gemäss Anspruch 11, dadurch gekennzeichnet, dass es einen Bisphenol-A- oder Bisphenol-F-diglycidylether enthält.

14. Verwendung der Zusammensetzung gemäss Anspruch 5 zur Herstellung von wärmeleitenden Formteilen und Verbundkörpern.

15. Verwendung des Giessharzes gemäss Anspruch 8 zur Herstellung von wärmeleitenden Formteilen.

16. Verwendung des Giessharzes gemäss Anspruch 8 als Klebharz zur Verbindung von Metallen oder als Versiegelungsmaterial für elektrische und elektronische Bauteile.

## Claims

1. A powder mixture of alumina with fractions of different particle size and external shape, which mixture comprises:
(1) 55 to 75 % by volume of spherical α-alumina, at least 90 % by weight of which has a particle diameter of 20 to 120 »m,
(2) 35 to 20 % by volume of spherical alumina, at least 90 % by weight of which has a particle diameter of 3 to 25 »m, and
(3) 10 to 1 % by volume of alumina with an irregular particle shape, at least 90 % by weight of which has a particle diameter of 1 to 7 »m,
the percentages by volume adding up to 100 %.

2. A mixture according to claim 1, which comprises
a) 65 to 75 % by volume of component (1),
b) 35 to 22 % by volume of component (2), and
c) 7 to 1 % by volume of component (3),
the percentages by volume adding up to 100 %.

3. A mixture according to claim 1, which comprises
a) 70 to 75 % by volume of component (1),
b) 30 to 22 % by volume of component (2), and
c) 7 to 1 % by volume of component (3),
the percentages by volume adding up to 100 %.

4. A mixture according to claim 1, wherein the particle diameter of component (1) is from 30 to 100 »m, that of component (2) is from 3 to 20 »m, and that of component (3) is from 1 to 5 »m.

5. A composition comprising in uniform distribution
a) 10 to 95 % by weight of a thermoplastic or structurally crosslinked polymer, and
b) 90 to 5 % by weight of the powder mixture according to claim 1.

6. A composition according to claim 5, which comprises 10 to 90 % by weight of polymer and 90 to 10 % by weight of the powder mixture.

7. A composition according to claim 5, wherein the structurally crosslinked polymer is an epoxy resin.

8. A casting resin based on epoxy resins, which comprises in uniform distribution 70 to 90 % by weight of the powder mixture according to claim 1, based on the casting resin.

9. A casting resin according to claim 8, which comprises 75 to 90 % by weight of the powder mixture.

10. A casting resin according to claim 8, which comprises 80 to 90 % by weight of the powder mixture.

11. A casting resin according to claim 8, which comprises as resin component a mixture of bisphenol diglycidyl ethers and a polycarboxylic anhydride as hardener.

12. A casting resin according to claim 11, which additionally comprises a curing accelerator.

13. A casting resin according to claim 11, which comprises a bisphenol A diglycidyl ether or a bisphenol F diglycidyl ether.

14. Use of a composition according to claim 5 for the production of thermally conductive moulded articles and composites.

15. Use of a casting resin according to claim 8 for the production of thermally conductive moulded articles.

16. Use of a casting resin according to claim 8 as resin adhesive for bonding metals or as sealing material for electrical and electronic components.

## Revendications

1. Mélange pulvérulent d'oxyde d'aluminium avec des fractions de particules de taille et de forme extérieure différentes, caractérisé en ce qu'il contient :
(1) de 55 à 75 % en volume d'oxyde d'aluminium α sphérique, dont au moins 90 % en poids présentent un diamètre de particules de 20 à 120 »m,
(2) de 35 à 20 % en volume d'oxyde d'aluminium sphérique dont au moins 90 % en poids présentent un diamètre de particules de 3 à 25 »m, et
(3) de 10 à 1 % en volume d'oxyde d'aluminium avec une forme de particules irrégulière dont au moins 90 % en poids présentent un diamètre de particules de 1 à 7 »m,
les pourcentages en volume s'additionnant à 100 %.

2. Mélange selon la revendication 1, caractérisé en ce qu'il contient :
a) de 65 à 75 % en volume du constituant (1),
b) de 35 à 22 % en volume du constituant (2), et
c) de 7 à 1 % en volume du constituant (3),
les pourcentages en volume s'additionnant à 100 %.

3. Mélange selon la revendication 1, caractérisé en ce qu'il contient
a) de 70 à 75 % en volume du constituant (1),
b) de 30 à 22 % en volume du constituant (2), et
c) de 7 à 1 % en volume du constituant (3),
les pourcentages en volume s'additionnant à 100 %.

4. Mélange selon la revendication 1, caractérisé en ce que le diamètre des particules du constituant (1) est de 30 à 100 »m, du constituant (2) de 3 à 20 »m et du constituant (3) de 1 à 5 »m.

5. Composition contenant en répartition uniforme
a) de 10 à 95 % en poids d'un polymère thermoplastique ou structurellement réticulé, et
b) de 90 à 5 % en poids du mélange pulvérulent selon la revendication 1.

6. Composition selon revendication 5, caractérisée en ce qu'elle contient de 10 à 90 % en poids de polymère et de 90 à 10 % en poids du mélange pulvérulent.

7. Composition selon revendication 5, caractérisée en ce qu'il s'agit dans le cas du polymère structurellement réticulé d'une résine époxyde.

8. Résine à couler à base de résines époxydes caractérisée en ce qu'elle contient en répartition uniforme de 70 à 90 % en poids du mélange pulvérulent selon la revendication 1, par rapport à la résine à couler.

9. Résine à couler selon la revendication 8, caractérisée en ce qu'elle contient de 75 à 90 % en poids du mélange pulvérulent.

10. Résine à couler selon la revendication 8, caractérisée en ce qu'elle contient de 80 à 90 % en poids du mélange pulvérulent.

11. Résine à couler selon la revendication 8, caractérisée en ce qu'elle contient en tant que constituant résine un mélange composé d'éthers diglycidyliques de bisphénol et d'un anhydride d'acide polycarboxylique en tant que durcisseurs.

12. Résine à couler selon la revendication 11, caractérisée en ce qu'elle contient de plus un accélérateur de durcissement.

13. Résine à couler selon la revendication 11, caractérisée en ce qu'elle contient de plus un éther diglycidylique du bisphénol A ou du bisphénol F.

14. Utilisation de la composition selon la revendication 5 pour la préparation de matériaux composites et de préformés thermoconducteurs.

15. Utilisation de la résine à couler selon la revendication 8 pour la préparation de préformés thermoconducteurs.

16. Utilisation de la résine à couler selon la revendication 8 en tant que résine adhésive pour l'assemblage de métaux ou en tant que matériau de scellement pour les composants électriques ou électroniques.
